# EUROPEAN PATENT APPLICATION

(11) **EP 3 419 252 A1**
(43) Date of publication of application: **26.12.2018**
(21) Application number: 17753110.0
(22) Date of filing: 13.02.2017
(51) Int. Cl.: H04L 29/08, H04W 28/04, H04W 28/06

(54) **WIRELESS BASE STATION, TERMINAL DEVICE, AND COMMUNICATION SYSTEM**

(30) Priority: 15.02.2016 JP 2016025431
(71) Applicant: NEC Corporation, Tokyo 108-8001 (JP)
(72) Inventor: DENG Lianjun, Tokyo 108-8001 (JP)
(74) Representative: MacDougall, Alan John Shaw
(86) International application number: PCT/JP2017/005074
(87) International publication number: WO 2017/141853

(57) **Abstract**

Provided is a communication system for preventing the wasteful consumption of a wireless band and a reduction in the immediacy of a response. A first wireless communication device in the communication system having the first wireless communication device and a second wireless communication device, wherein the first wireless communication device has a first restorer for restoring a packet and a first compressor for compressing a packet, and the second wireless communication device has a second restorer for restoring a packet and a second compressor for compressing a packet. A session group corresponding to a plurality of sessions is set between the first compressor and the second restorer, and the first compressor transmits to the second restorer a message that pertains to the restoration condition of the packet and that corresponds to the session group.

## Description

### [Technical Field]

The present invention relates to a communication system including a wireless base station and a terminal device.

### [Background Art]

In a wireless communication system, a packet is compressed in order to promote efficiency of wireless resource utilization and efficiency of data transfer. A wireless base station and a terminal device are each provided with a compressor for compressing a packet, and a restorer for restoring the compressed packet by being decompressed. Among packet compression methods, a method called Robust Header Compression (ROHC) control is employed to perform compression and restoration on a header of each packet to be transmitted and received between the wireless base station and the terminal device.

An overall flow in the ROHC control will be described below. First, the wireless base station or the terminal device, which is defined as a packet transmitting side, receives a packet from a core network or a user. Further, the packet whose header is compressed by a compressor is transmitted to a restorer in another device defined as a packet receiving side. The restorer which receives the packet sets a message regarding a restoration state of the header of the packet in a packet to be input to a compressor on the packet receiving side, and transmits the packet to a restorer in the device on the packet transmitting side via the compressor. Specifically, this message is a message indicating whether or not restoration of the header of the packet is successful.

Further, the restorer on the packet transmitting side reflects the received message in a compressor on the packet transmitting side. In this case, the restorer on the packet transmitting side requests the compressor on the packet transmitting side to transmit context information necessary for restoration of the header of the packet.

A request for the context information and transmission of the context information are carried out in each session existing for each data communication path Data Radio Bearer (DRB) between the wireless base station and the terminal device (PTL 1). Each message is identified by a Context Identifier (CID) set for each session (NPL 1).

### [Citation List]

### [Patent Literature]

[PTL 1] International Patent Publication No. WO 2012/108215
[NPL 1] Internet Engineering Task Force (IETF) Request for Comments: 5795

### [Summary of Invention]

### [Technical Problem]

When a restoration error occurs in a plurality of sessions in one DRB, transmission and reception of a same STATIC-NACK message are performed in a plurality of sessions in the DRB. In this case, the following problems are caused. First, a compressor transmits a large number of identical messages, which leads to wasteful consumption of a wireless band. Further, a restorer sequentially performs processing, based on the received STATIC-NACK message, which leads to deterioration in immediacy of a response. The deterioration in immediacy of a response may cause deterioration in communication quality.

### [Solution to Problem]

A first wireless communication device in a communication system including the first wireless communication device and a second wireless communication device, the first wireless communication device, according to the present invention, comprises
a first restorer configured to restore a packet, and a first compressor configured to compress a packet, wherein
the second wireless communication device includes a second restorer configured to restore a packet, and a second compressor configured to compress a packet,
a session group corresponding to a plurality of sessions is set between the first compressor and the second restorer, and
the first compressor transmits, to the second restorer, a message regarding a restoration state of the packet, the message corresponding to the session group.

### [Advantageous Effects of Invention]

With this configuration, it is possible to reduce the number of identical messages which indicate a restoration state of a packet and which are transmitted and received in a plurality of sessions set for one session group. Further, with this configuration, it is possible to prevent wasteful consumption of a wireless band and deterioration in immediacy of a response.

### [Brief Description of Drawings]

Fig. 1 is a block diagram illustrating an example of a communication system according to the present invention;
Fig. 2 is a block diagram illustrating a configuration of a communication system according to a first example embodiment;
Fig. 3 is a sequence diagram illustrating an operation according to the first example embodiment;
Fig. 4 is a sequence diagram illustrating an operation according to the first example embodiment;
Fig. 5 is a block diagram illustrating a configuration of a communication system according to a second example embodiment;
Fig. 6 is a diagram illustrating pieces of identification information according to the present invention;
Fig. 7 is a flowchart illustrating an operation according to the second example embodiment; and
Fig. 8 is a block diagram illustrating a configuration of a communication system according to a third example embodiment.

### [Example Embodiment]

Example embodiments of the present invention will be described in detail below with reference to the drawings.

Each of a first wireless communication device and a second wireless communication device may be a wireless base station, a terminal device, or the like.

In the following example embodiments, the first wireless communication device is referred to as a packet receiving side and the second wireless communication device is referred to as a packet transmitting side, but are replaceable with each other.

Further, the following example embodiments are described assuming that the packet receiving side corresponds to a wireless base station 1 and the packet transmitting side corresponds to a terminal device 2, but are replaceable with each other. When 1 denotes a terminal device and 2 denotes a wireless base station, similar descriptions are applied only by replacing the terminal device with the wireless base station.

Further, compression and restoration of each packet are described below, but instead the header of each packet may be compressed and restored.

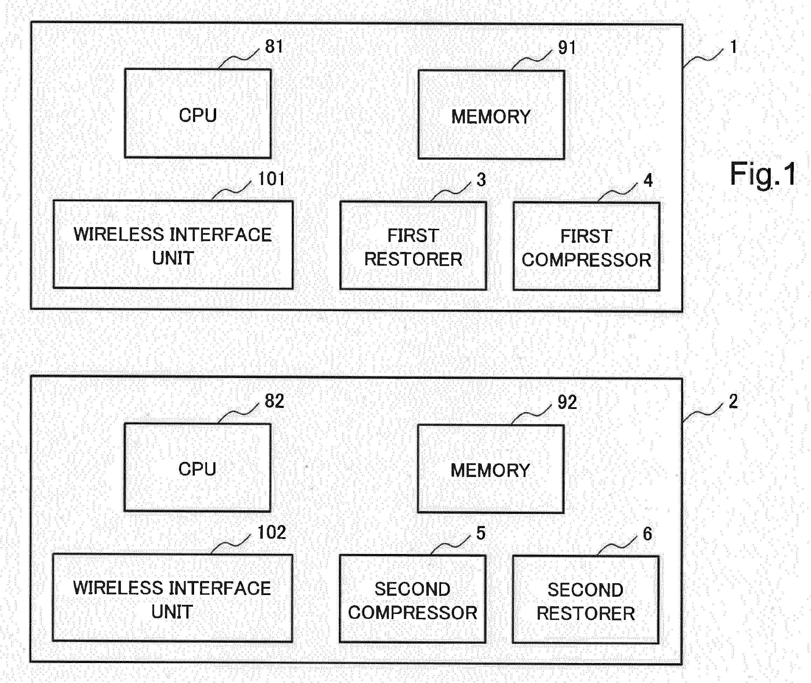

Fig. 1 is a block diagram illustrating an example of a communication system according to the present invention. The wireless base station 1 includes a first restorer 3, a first compressor 4, a control unit 81, a memory 91, and a wireless interface unit 101. The terminal device 2 includes a second compressor 5, a second restorer 6, a control unit 82, a memory 92, and a wireless interface unit 102. The wireless base station 1 and the terminal device can communicate with each other via the wireless interface units 101 and 102, respectively.

### (First Example Embodiment)

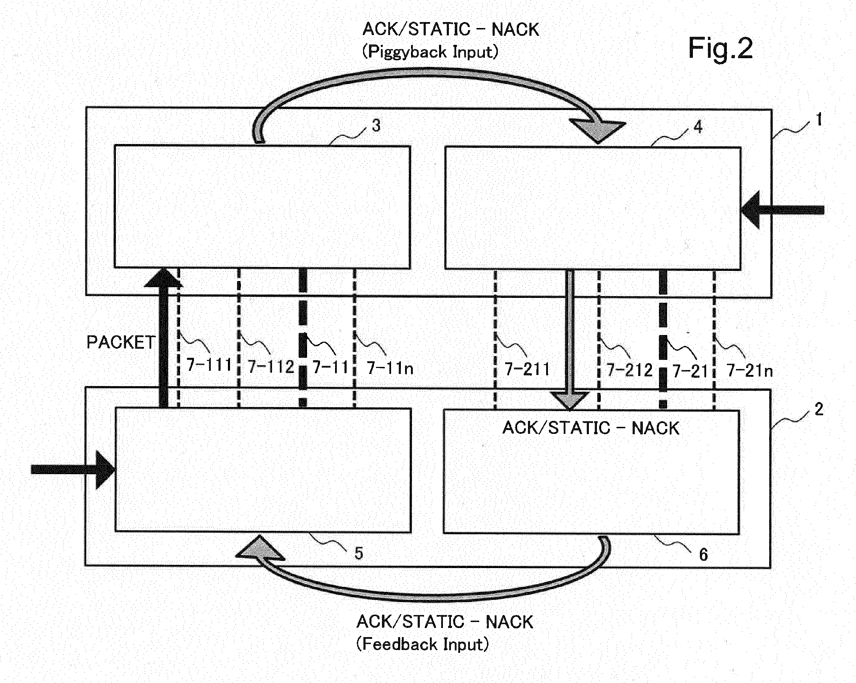

Fig. 2 is a block diagram illustrating a configuration of a communication system according to a first example embodiment of the present invention. In the drawings described below, illustration of a control unit, a memory, and a wireless interface unit is omitted.

A plurality of sessions 7-111 to 7-11n and a plurality of sessions 7-211 to 7-21n (n is an arbitrary integer) are set between the first restorer 3 and the second compressor 5 and between the first compressor 4 and the second restorer 6, respectively. The sessions 7-111 to 7-11n are collectively referred to as a session group 7-11 and the sessions 7-211 to 7-21n are collectively referred to as a session group 7-21.

Note that a variation pattern of each session is context information. The context information is a packet or the like obtained before being compressed. This is used for compression and restoration of a packet. The context information is identified by a Context IDentifier (CID).

A packet input to the second compressor 5 is compressed by the second compressor 5 and transmitted to the first restorer 3. When restoration of the packet is successful in the first restorer 3, an ACK message (a message indicating that the restoration of the packet is successful) is transmitted to the second restorer 6 via the first compressor 4. The message is also transmitted to the second compressor 5. Further, when the restoration of the packet is unsuccessful in the first restorer 3, a STATIC-NACK message is transmitted to the second compressor 5 by a route similar to that for the above-mentioned ACK message. Note that, for example, the determination as to whether the restoration of the packet is successful or unsuccessful may be performed based on a header of the packet or context information included in the packet. For example, when restoring a compressed header, the first restorer 3 uses the context information included in the header received before the restoration. When it is detected that the context information is lost or damaged, the first restorer 3 cannot restore the compressed header after that. In this case, the restoration of the packet including the header is unsuccessful.

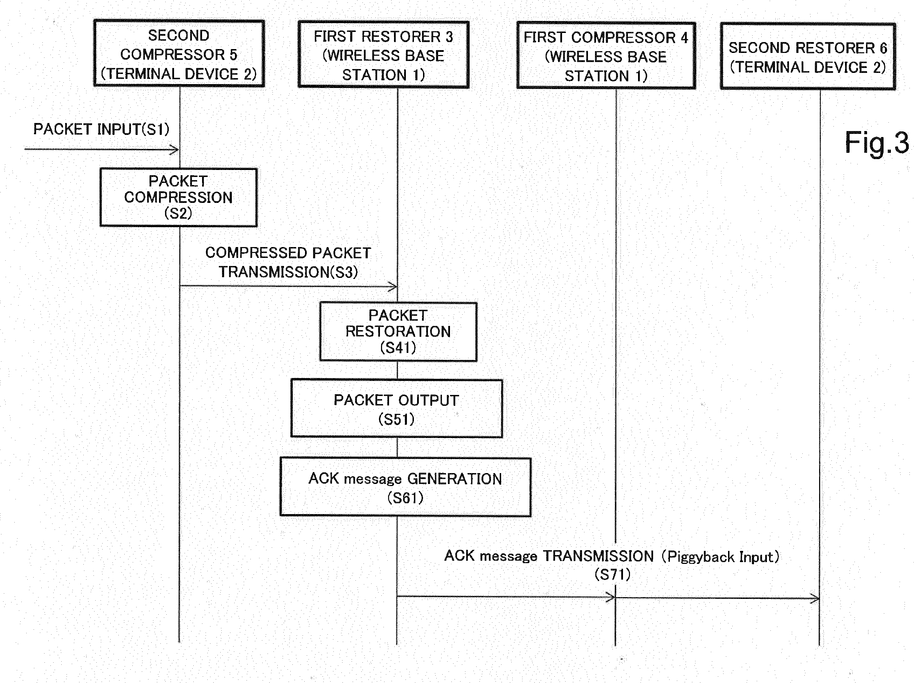

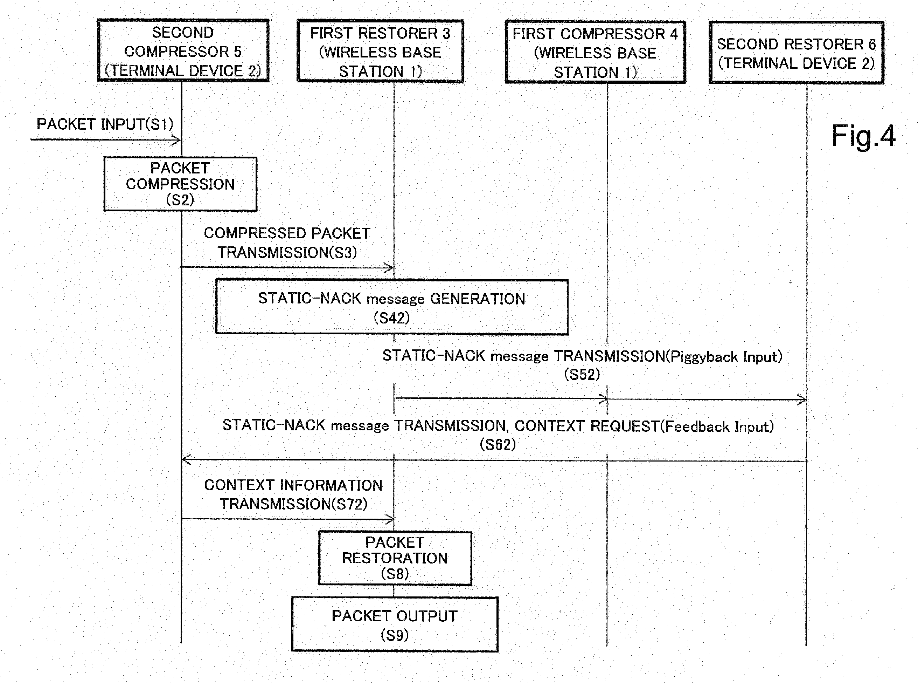

An operation according to this example embodiment will be described below by using sequence diagrams of Figs. 3 and 4.

First, a user packet (audio etc.) is input to the second compressor 5 in the terminal device 2 (S1). The second compressor 5 compresses the packet (S2), and transmits the compressed packet to the first restorer 3 in the wireless base station 1 (S3).

Next, when the restoration of the packet is successful, the first restorer 3 outputs the restored packet as illustrated in Fig. 3 (S41, S51). Further, the first restorer 3 generates a message (ACK message) to notify that the restoration is successful (S61). Further, the first restorer 3 sets this message in a data packet to be input to the first compressor 4, and transmits the data packet to the second restorer 6 in the terminal device 2 via the first compressor 4 (S71). This message may be transmitted by Piggyback Input. In this case, a single ACK message, which is made to correspond to one session group 7-21, is transmitted from the first compressor 4 to the second restorer 6.

On the other hand, when a restoration error occurs due to deterioration in wireless propagation environment or the like, the second restorer 6 requests the second compressor 5 to send information necessary for packet restoration after the wireless propagation environment is improved and the data transmission is resumed. This request operation is carried out according to the following procedure as illustrated in Fig. 4.

The first restorer 3 generates a message (STATIC NACK message) to notify a restoration error as a restoration state (S42). Further, the first restorer 3 sets this message in a data packet to be input to the first compressor 4, and transmits the data packet to the second restorer 6 in the terminal device 2 via the first compressor 4 (S52). This message may be transmitted by Piggyback Input. In this case, a single STATIC NACK message, which is made to correspond to one session group 7-21, is transmitted from the first compressor 4 to the second restorer 6.

Next, the second restorer 6 reflects information about the STATIC-NACK message in the context information of the second compressor 5 in the terminal device 2. The information about this message may be reflected by Feedback Input. At the same time, the second restorer 6 requests the second compressor 5 in the terminal device 2 to sent context information necessary for restoration of the packet (S62).

Further, the second compressor 5 transmits context information necessary for restoration of the packet to the first restorer 3 in the wireless base station 1 (S72). As a result, the first restorer 3 can restore the packet and output the restored packet (S8, S9).

According to the communication system using the wireless base station in accordance with this example embodiment, it is possible to complete packet restoration processing by transmitting or receiving only one message which indicates the restoration state of the packet and is transmitted and received in one session group.

### (Second Example Embodiment)

The first example embodiment will be described in more detail in a second example embodiment.

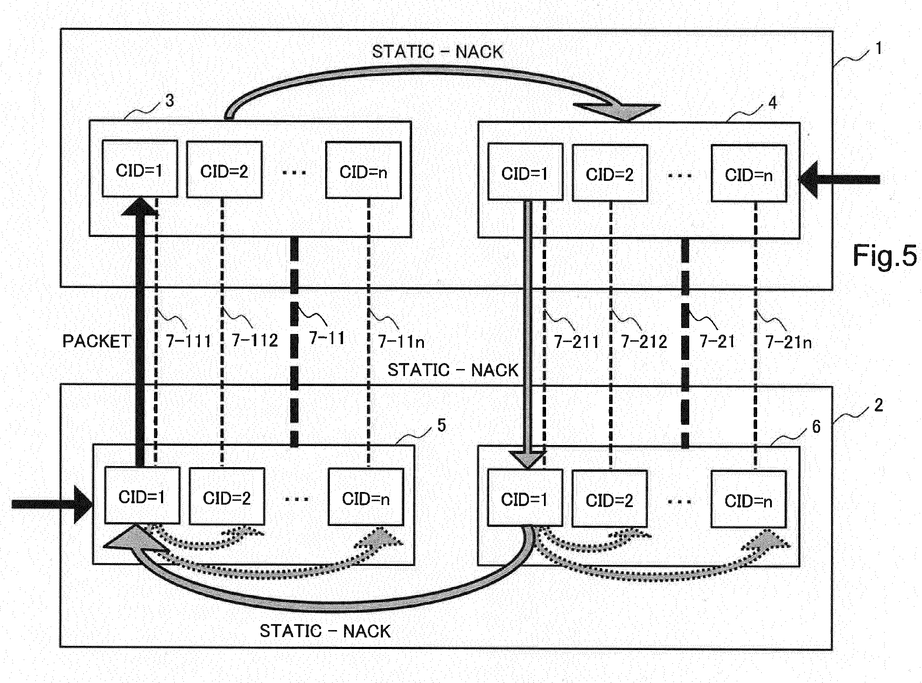

Fig. 5 is a block diagram illustrating a configuration of a communication system according to an example embodiment of the present invention.

At a time of starting communication, a wireless bearer is set as a communication path in a Packet Data Convergence Protocol (PDCP) layer of each of the wireless base station 1 and the terminal device 2. PDCP entities respectively corresponding to the wireless bearers are generated in the wireless base station 1 and the terminal device 2. These PDCP entities in this example embodiment correspond to the first restorer 3, the second restorer 6, the first compressor 4, and the second compressor 5. Each PDCP entity holds control information for data packets to be transmitted and received by using the wireless bearers.

The wireless bearers include a Signaling Radio Bearer (SRB) and a Data Radio Bearer (DRB). In this example embodiment, DRB is set as a wireless bearer.

In this example embodiment, the session group described above is set for each wireless bearer. Specifically, the session groups 7-11 and 7-21 are set for each wireless bearer.

An operation according to this example embodiment is carried out in a manner similar to the first example embodiment by using Figs. 3 and 4.

In the step S71 illustrated in Fig. 3 and the step S52 and subsequent steps illustrated in Fig. 4, characteristic operations in this example embodiment will be described in detail by using Fig. 5.

In this example embodiment, the second restorer 6 receives, for example, an ACK message or a STATIC-NACK message corresponding to one session 7-211 among the plurality of sessions 7-211 to 7-21n set in the session group 7-21.

This message may be a message regarding the packet restoration state in two or more sessions in the session group 7-21. In this case, upon reception of this message, the second restorer 6 can recognize not only the packet restoration state in the session 7-211, but also the packet restoration state in some or all of the sessions 7-212 to 7-21n.

In this message, identification information that is different from the Context IDentifier (CID) set in a plurality of sessions and corresponds to the session group may be set.

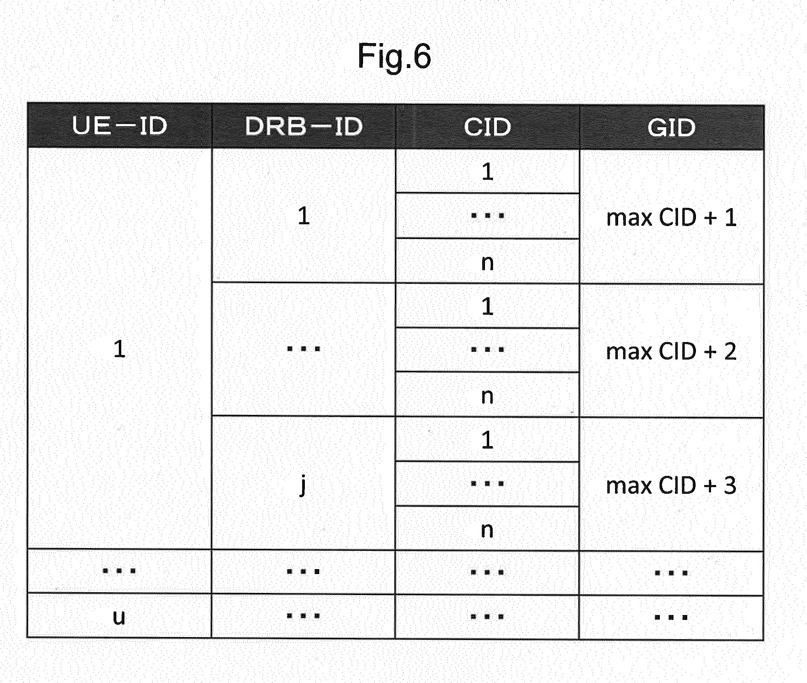

Further, the identification information may be set for each wireless bearer. For example, in this example embodiment, the Group IDentifier (GID) illustrated in Fig. 6 is set.

The GID can be set by, for example, adding an arbitrary value (an integer equal to or greater than 1 in Fig. 6) to a max CID (a CID maximum value that can be used by a compressor and a restorer). A DRB-ID (which takes an arbitrary integer in a range of values 1 to j in this example embodiment), which is an ID of a wireless bearer, may overlap the CID. Accordingly, setting of the GID like in this example embodiment enables setting of a new ID that can be distinguished from the ID of the DRB and the CID.

However, any ID may be used as the GID as long as the ID is different from the CID. The GID may be an ID that is the same as the DRB-ID, or may be an ID that is the same as a User Equipment (UE)-IDentifier (ID) of a terminal device. In Fig. 6, it is assumed that the UE-ID takes an arbitrary integer in a range of values 1 to u.

In this case, a condition in which a STATIC-NACK message is made to correspond to a session group and transmitted may be set in advance.

Specifically, for example, a threshold is set. When the number of sessions in which the packet restoration state indicates a restoration error among the sessions 7-211 to 7-21n in the session group 7-21 exceeds a preset threshold, the STATIC-NACK message which is made to correspond to the session group may be transmitted. In this case, the GID may be set in this message.

A threshold may be set depending on a measurement result of the number of restoration errors in the actual wireless environment. For example, the threshold may be the number of restoration errors per unit time (the number of sessions in which a restoration error occurs) in all sessions set in a session group in which a restoration error occurs within a certain period of time.

As the number of restoration errors, "1" is set when a restoration error occurs in one session. Note that even when a plurality of times of restoration errors occur in the same session, "1" is set as the number of restoration errors. With this configuration, the wireless environment of the entire sessions set in the session group can be recognized.

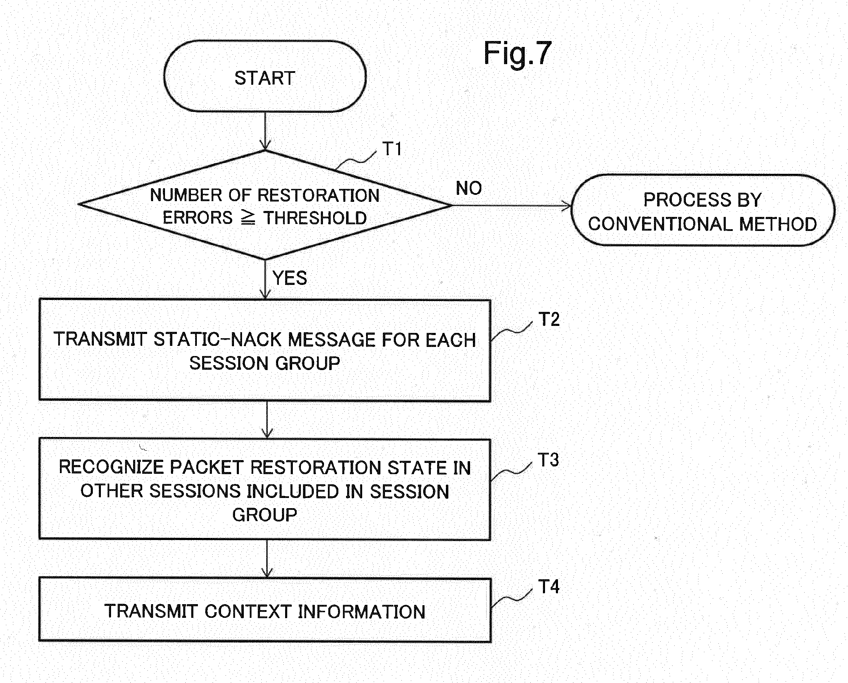

An operation to be performed in this case will be described by using Fig. 7.

The description using Fig. 5 uses such an expression that the session group is represented by the session group 7-21 and the plurality of sessions 7-211 to 7-21n are set in the session group 7-21. For convenience of explanation, the description using Fig. 7 uses such an expression that a plurality of sessions with CIDs=1 to n are set in the session group, but the expression indicates the same content.

### (Step T1)

It is assumed that the control unit 81 in the wireless base station 1 periodically acquires a session use state (the number of connected sessions and the number of sessions in which the packet restoration state indicates a restoration error) via the wireless interface unit 101 by using a Radio Resource Control (RRC) message. The control unit 81 sets the above-mentioned threshold for the number of sessions in which the packet restoration state indicates a restoration error. Further, it is determined whether or not the number of sessions in which the packet restoration state indicates a restoration error exceeds a threshold.

### (Step T2)

When the acquired number of sessions in which the packet restoration state indicates a restoration error is equal to or greater than a preset threshold, it is determined that the STATIC-NACK message is a target to be transmitted from the first compressor 4 to the second restorer 6 by a transmission method defined in this example embodiment. Specifically, the transmission method defined in this example embodiment is a method of transmitting a STATIC-NACK message which is made to correspond to a session group.

In this example embodiment, this message is made to correspond to the session with CID=1, which is a CID minimum value, and the GID is set in the message, and then the message is transmitted. In sessions (sessions with CIDs=2 to n in this case) other than the session with CID=1 in the session group of CIDs=1 to n, the first restorer 3 does not transmit this message. In this case, it is assumed that this message indicates a packet restoration state in sessions with CIDs=1 to n.

On the other hand, when the number of sessions in which the packet restoration state indicates a restoration error is less than a preset threshold, the first compressor 4 determines that the transmission by the transmission method cannot be executed, and thus the transmission is processed by a conventional method. Specifically, the first compressor 4 transmits a STATIC-NACK message which is made to correspond to each session.

### (Step T3)

The second restorer 6 receives the STATIC-NACK message corresponding to the session with CID=1. Further, the control unit 82 recognizes a session in which the packet restoration state indicates a restoration error, also with regard to sessions (CIDs=2 to n in this case) other than one session (session with CID=1 in this case) corresponding to the STATIC-NACK message in the session group. For example, when a session in which the packet restoration state indicates a restoration error and a session in which a packet restoration state does not indicate a restoration error are present, the control unit 82 may recognize (reconsider) that all sessions (CIDs=1 to n) are sessions in which the packet restoration state indicates a restoration error. For example, in a certain session group, when the number of sessions in which the packet restoration state indicates a restoration error is eight and the number of sessions in which a packet restoration state does not indicate a restoration error is two, it is considered that two sessions are sessions in which the packet restoration state indicates a restoration error.

Further, the control unit 82 stores, in the memory 92, the sessions in which the packet restoration state indicates a restoration error.

After that, the second restorer 6 transmits a STATIC-NACK message to the second compressor 5 by Feedback Input. At the same time, the second restorer 6 requests the second compressor 5 to send context information necessary for packet restoration.

In this case, this request message may be linked to the session with CID=1 and transmitted from the second restorer 6 to the second compressor 5. In this case, when the second compressor 5 receives this request message, the control unit 82 may link this request message to sessions in which context information is requested, also with regard to a session of sessions (CIDs=2 to n) other than the session with CID=1, in the second compressor 5.

Note that this message may be transmitted from the second restorer 6 to the second compressor 5 for each session.

### (Step T4)

The second compressor 5 which has received the STATIC-NACK message transmits all pieces of context information necessary for packet restoration to the first restorer 3. This context information is, for example, a user packet (audio etc.) obtained before being compressed. This context information may also be linked only to one session and transmitted, or may be transmitted every two or more sessions in the session group.

According to the communication system using the wireless base station according to this example embodiment, a packet compressor transmits only one message regarding a restoration state of a packet to a packet restorer on a wireless bearer to which one session group in which a plurality of sessions are set is set, thereby making it possible to notify the message for a plurality of sessions set to the wireless bearer, and to complete packet restoration processing.

### (Third Example Embodiment)

Next, a third example embodiment will be described.

In this example embodiment, an ACK message or STATIC-NACK message corresponds to a session group and a session group is set for each terminal device.

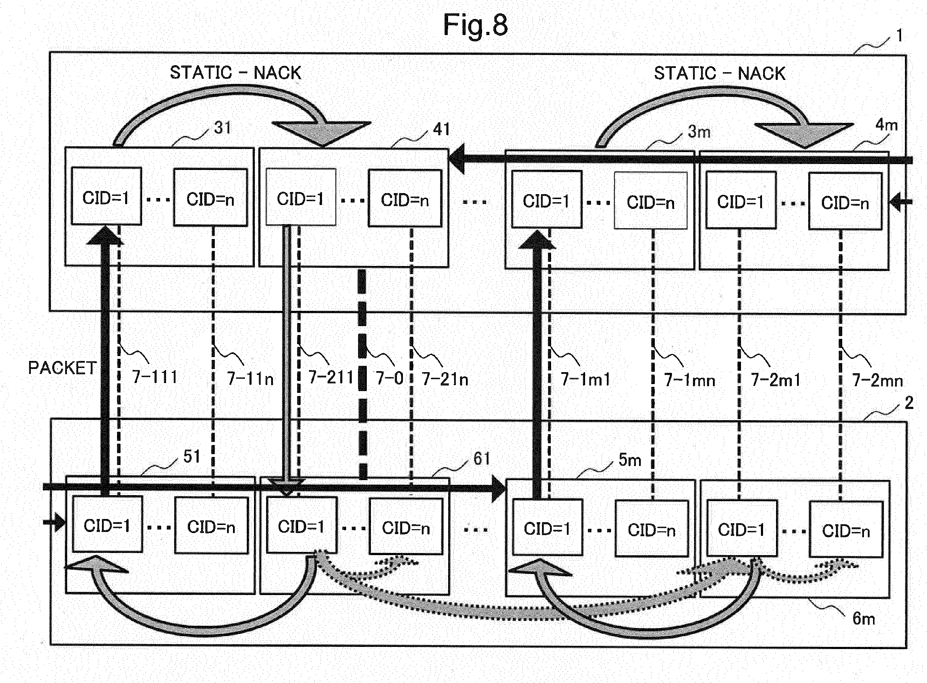

For example, a case of a communication system as illustrated in Fig. 8 will be described.

Referring to Fig. 8, the wireless base station 1 includes a plurality of first restorers 31 to 3m (m is an arbitrary integer) and a plurality of first compressors 41 to 4m. The terminal device 2 includes a plurality of second compressors 51 to 5m and a plurality of second restorers 61 to 6m.

A plurality of sessions 7-111 to 7-11n are set between the first restorer 31 and the second compressor 51. Similarly, a plurality of sessions 7-1m1 to 7-1mn are set between the first restorer 3m and the second compressor 5m. Further, a plurality of sessions 7-211 to 7-21n are set between the first compressor 41 and the second restorer 61. Similarly, a plurality of sessions 7-2m1 to 7-2mn are set between the first compressor 4m and the second restorer 6m.

In this example embodiment, a session group is set for each terminal device 2. Specifically, a plurality of sessions 7-111 to 7-11n, 7-1m1 to 7-1mn, 7-211 to 7-21n, and 7-2m1 to 7-2mn set between the wireless base station 1 and the terminal device 2 are collectively set as one session group. In Fig. 8, one session group 7-0 is set between the first compressor 41 and the second restorer 61.

Further, a connection between the first compressors 41 to 4m and the second restorers 61 to 6m, and a connection between the first restorers 31 to 3m and the second compressors 51 to 5m may be established by using a wireless bearer.

An operation according to this example embodiment is carried out in a manner similar to the first and second example embodiments described by using Figs. 3 and 4.

In the step S71 illustrated in Fig. 3 and the step S52 and subsequent steps illustrated in Fig. 4, characteristic operations in this example embodiment will be described in detail by using Fig. 8.

In this example embodiment, for example, the second restorer 61 receives, for example, the ACK message or STATIC-NACK message corresponding to one session 7-211 among the plurality of sessions set in the session group 7-0.

This message may be a message regarding a packet restoration state in two or more sessions in the session group 7-0, as described in the second example embodiment. In this case, for example, upon reception of this message, the second restorer 61 can recognize not only the packet restoration state in the session 7-211, but also the packet restoration state in some or all of the sessions 7-212 (not illustrated) to 7-21n.

Further, in this example embodiment, this message may be a message regarding a packet restoration state in second restorers 62 (not illustrated) to 6m other than the second restorer 61 included in the terminal device 2. With this configuration, the second restorer 61 can also recognize the packet restoration state in the second restorers 62 to 6m.

Note that the above-mentioned GID may be set in this message.

Subsequent operations in which a message is transmitted from the second restorer 61 to the second compressor 51 are carried out in a manner similar to the first and second example embodiments. Also, in this example embodiment, a threshold may be set for the number of restoration errors as described in the second example embodiment.

According to the communication system using the wireless base station in accordance with this example embodiment, the terminal device or the wireless base station includes a plurality of restorers, and even when restoration errors occur in a plurality of restorers, a packet compressor transmits only one message regarding a restoration state of a packet to a packet restorer, thereby making it possible to notify the message for a plurality of sessions set as a session group and complete packet restoration processing.

While the invention has been particularly shown and described. The invention is not limited to these embodiments, and various modifications can be made within the scope of the subject matter of the present invention. The example embodiments described above are illustrated by way of example, and it can be understood by those skilled in the art that combinations of the example embodiments and combinations of components and processing processes in the example embodiments can be modified in various ways and the modified examples are also included in the scope of the present invention.

For example, steps in the processing described herein need not necessarily be executed in chronological order according to the order described in each sequence diagram. For example, steps in the processing may be executed in an order different from the order described in each sequence diagram, or may be executed in parallel.

Further, the wireless base station described herein may include components such as a communication processing unit, a request unit, an information acquisition unit, and/or a report unit. Further, a module (e.g., a wireless base station device, or a module for a wireless base station device) including these components may be provided. Furthermore, a method including the processing for the components may be provided, and a program for causing a processor to execute the processing for the components may also be provided. In addition, a recording medium recording the program may be provided. As a matter of course, the module, the method, the program, and the recording medium are also included in the present invention.

Further, the terminal device described herein may include components such as a Radio Frequency (RF) transceiver, an antenna, a baseband processor, an application processor, and a memory.

The RF transceiver (RF) transceiver performs analog RF signal processing for communicating with the wireless base station. The analog RF signal processing performed by the RF transceiver may include frequency up-conversion, frequency down-conversion, and amplification. The RF transceiver may be connected to each of an antenna and a baseband processor. Specifically, the RF transceiver may receive, from the baseband processor, modulation symbol data (or Orthogonal Frequency Division Multiplexing (OFDM) symbol data), generate a transmission RF signal, and supply a transmission RF signal to the antenna. Further, the RF transceiver may generate a baseband reception signal based on a reception RF signal received by the antenna, and supply the baseband reception signal to the baseband processor.

The baseband processor performs digital baseband signal processing (data plane processing) and control plane processing for wireless communication. The digital baseband signal processing may include (a) data compression/restoration, (b) data segmentation/concatenation, (c) generation/decomposition of a transmission format (transmission frame), (d) transmission path coding/decoding, (e) modulation (symbol mapping)/demodulation, and (f) generation of OFDM symbol data (baseband OFDM signal) by Inverse Fast Fourier Transform (IFFT). On the other hand, the control plane processing may include communication management of a layer 1 (e.g., transmission power control), a layer 2 (e.g., wireless resource management and hybrid automatic repeat request (HARQ) processing), and a layer 3 (e.g., signaling related to attach, mobility, and call management).

For example, in the case of Long-Term Evolution (LTE) and LTE-Advanced, digital baseband signal processing to be performed by a baseband processor may include signal processing in a Packet Data Convergence Protocol (PDCP) layer, a Radio Link Control (RLC) layer, a Medium Access Control (MAC) layer, and a Physical (PHY) layer. Further, control plane processing to be performed by a baseband processor 2003 may include processing using a Non-Access Stratum (NAS) protocol, a Radio Resource Control (RRC) protocol, and a MAC Control Element (MAC CE).

The baseband processor may include a modem processor (e.g., Digital Signal Processor (DSP)) for performing digital baseband signal processing, and a protocol stack processor (e.g., Central Processing Unit (CPU), or Micro Processing Unit (MPU)) for performing control plane processing. In this case, the protocol stack processor for performing control plane processing may be commonly used as an application processor to be described below.

The application processor is also referred to as a CPU, an MPU, a microprocessor, or a processor core. The application processor may include a plurality of processors (a plurality of processor cores). The application processor executes a system software program (Operating System (OS)) loaded from the memory or a memory not illustrated, and various application programs (e.g., a call application, a WEB browser, a mailer, a camera operation application, and a music playback application), thereby implementing various functions of the terminal device.

In some implementations, a baseband processor and an application processor may be integrated on one chip. In other words, a baseband processor and an application processor may be implemented as one System on Chip (SoC) device. The SoC device is also referred to as a system Large Scale Integration (LSI) or a chip set.

The memory is a volatile memory, a nonvolatile memory, or a combination thereof. The memory may include a plurality of memory devices which are physically independent. The volatile memory is, for example, a Static Random Access Memory (SRAM), a Dynamic RAM (DRAM), or a combination thereof. The nonvolatile memory is a Mask Read Only Memory (MROM), an Electrically Erasable Programmable ROM (EEPROM), a flash memory, a hard disk drive, or any combination thereof. Examples of the memory may include an external memory device accessible from the baseband processor, the application processor, and the SoC. The memory may also include a built-in memory device integrated in the baseband processor, in the application processor, or in the SoC. Further, the memory may include a memory within a Universal Integrated Circuit Card (UICC).

The memory may store a software module (computer program) including an instruction group and data for processing to be performed by the terminal device described in the plurality of example embodiments. In some implementations, the baseband processor or the application processor may be configured to read the software module from the memory and execute the software module, to thereby perform processing for the terminal device described in the example embodiments.

This application is based upon and claims the benefit of priority from Japanese patent application No. 2016-025431, filed on February 15, 2016, the disclosure of which is incorporated herein in its entirety by reference.

### [Reference signs List]

- 1: Wireless base station
- 2: Terminal device
- 3: First restorer
- 4: First compressor
- 5: Second compressor
- 6: Second restorer
- 81, 82: CPU (control unit)
- 91, 92: Memory
- 101, 102: Wireless interface unit

## Claims

1. A first wireless communication device in a communication system including the first wireless communication device and a second wireless communication device, the first wireless communication device comprising
a first restorer configured to restore a packet, and a first compressor configured to compress a packet, wherein
the second wireless communication device includes a second restorer configured to restore a packet, and a second compressor configured to compress a packet,
a session group corresponding to a plurality of sessions is set between the first compressor and the second restorer, and
the first compressor transmits, to the second restorer, a message regarding a restoration state of the packet, the message corresponding to the session group.

2. The first wireless communication device according to Claim 1, wherein
the session group is set for each wireless bearer.

3. The first wireless communication device according to Claim 1, wherein
the session group is set for each of the second wireless communication devices.

4. The first wireless communication device according to any one of Claims 1 to 3, wherein
identification information that is different from a context identifier (CID) set in the plurality of sessions and corresponds to the session group is set in the message.

5. The first wireless communication device according to any one of Claims 1 to 4, wherein
the message is a message corresponding to one of the plurality of sessions.

6. The first wireless communication device according to any one of Claims 1 to 5, wherein
the message is a message regarding a restoration state of the packet in two or more sessions in the session group.

7. The first wireless communication device according to any one of Claims 1 to 6, wherein
a restoration state of the packet indicates a restoration error.

8. The first wireless communication device according to Claim 7, wherein
the second restorer transmits a request for context information to the second compressor, and
the first restorer restores the packet, based on the context information received from the second compressor.

9. The first wireless communication device according to Claim 7 or 8, wherein,
when a number of the sessions in which a restoration state of the packet indicates a restoration error among the sessions in the session group exceeds a preset threshold, the first compressor transmits the message to the second restorer.

10. A first wireless communication device in a communication system including the first wireless communication device and a second wireless communication device, the first wireless communication device comprising
a first restorer configured to restore a packet, and a first compressor configured to compress a packet, wherein
the second wireless communication device includes a second restorer configured to restore a packet, and a second compressor configured to compress a packet,
a session group corresponding to a plurality of sessions is set between the first restorer and the second compressor, and
the first restorer receives, from the second compressor, a message regarding a restoration state of the packet, the message corresponding to the session group.
